# EUROPEAN PATENT SPECIFICATION

(11) **EP 0 587 294 B1**
(45) Date of publication and mention of the grant of the patent: **18.11.1998**
(21) Application number: 93306098.0
(22) Date of filing: 02.08.1993
(51) Int. Cl.: H01L 23/495, H05K 1/18

(54) **Semiconductor package**
Halbleiterpackung
Empaquetage semi-conducteur

(30) Priority: 08.09.1992 KR 1633792
(43) Date of publication of application: 16.03.1994
(73) Proprietor: Samsung Electronics Co., Ltd., Suwon-city, Kyungki-do (KR)
(72) Inventor: Lee, Joon Ki, Songdong-gu, Seoul (KR); Jeong, Hyeon Jo, Puk-gu, Inchon (KR); Kim, Kyung Sub, Kwanak-gu, Seoul (KR); Kwon, Oh-sik, Unpyong-gu, Seoul (KR)
(74) Representative: Sturt, Clifford Mark

(56) References cited:
- EP-A- 0 333 374
- EP-A- 0 427 151
- US-A- 5 032 953
- PATENT ABSTRACTS OF JAPAN vol. 12, no. 435 (E-683)16 November 1988 & JP-A-63 169 055 (NEC CORP)

## Description

The present invention relates to a vertical surface mounted semiconductor package which may be firmly mounted vertically on a printed circuit board (PCB) by forming a protrusion part on its body.

Recently, because of trends toward higher density, higher capacity of memory devices, fast signal processing speed, increasing power consumption, multi-function, and higher packing density, the importance of semiconductor packages is increasing. Along with higher density and capacity of semiconductor chips and memory devices, the number of input and output pin leads is increasing and a fine pitch between the leads is required. Also, in order to dissipate the large amount of heat generated in the semiconductor chip, because of the increase in operating speed and power consumption, an additional heat sink is formed in the semiconductor, or the package body is made of materials having a high thermal conductivity. With multi-function of the semiconductor chip, semiconductor packages with a variety of functions are required. In addition, because of the demands for high-density mounting of the semiconductor chips, investigations on stacked mounting of the semiconductor packages or direct mounting of the semiconductor chips into the PCB are proceeding.

In general, the semiconductor chips such as IC and LSI are sealed in a package and mounted on the PCB. In case of standard packages, the semiconductor chip is loaded on a metal die pad which acts as a heat sink. The electrode pads on the semiconductor chip are connected with leads for connection with external circuits by bonding wires, and the package body, made of epoxy moulding compound (EMC), protects the semiconductor chip and the bonding wires. In these semiconductor packages, dual in line package (DIP) types are known, where the leads are on opposite sides of the package and protruded in the vertical direction, and quad flat package (QFP) types, where the leads protrude from four sides of the package, are also known. Since the QFP can form more leads than the DIP, it enhances the mounting density on the PCB.

In the meantime, in order to enhance the mounting density of the packages, vertical package (VPAK) and vertical surface mounted package (VSMP), which occupy a small area due to vertical mounting on the PCB, are being investigated.

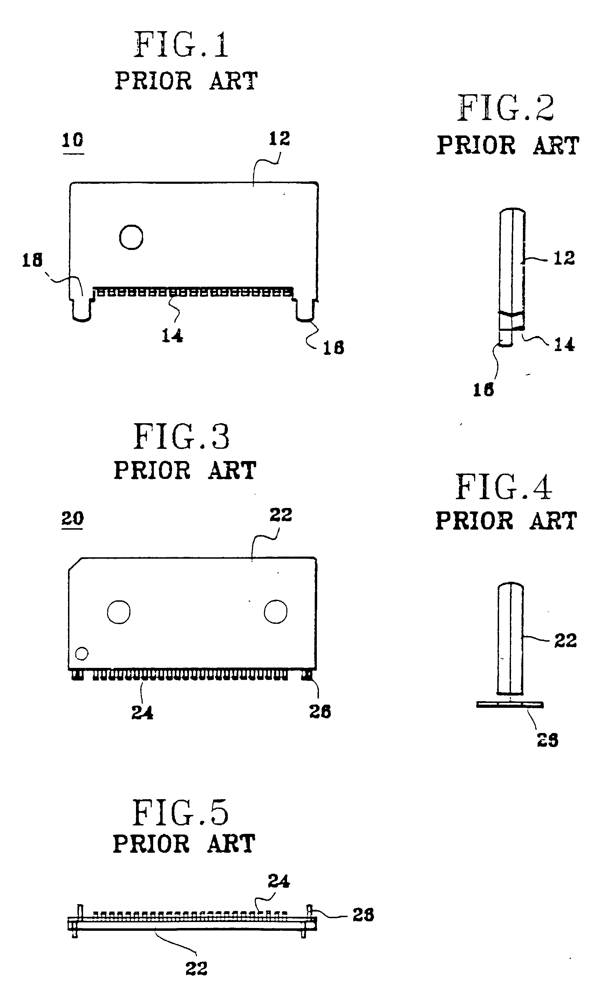

Figures 1 and 2 of the accompanying drawings show a conventional VPAK, 10.

A plurality of leads 14, which are connected to the PCB (not shown), protrude from one side of a rectangular package body 12 on which the semiconductor chip (not shown) is mounted. The leads 14 are all bent in the same direction. Also, support parts 16 protrude at both ends of the side of the package body 12 from which the leads protrude. The support parts 16 are formed of the EMC that forms the package body 12 and protrude further than the leads 14. Further, the support parts 16 have shoulders 18 at their middle to protect the bent leads 14.

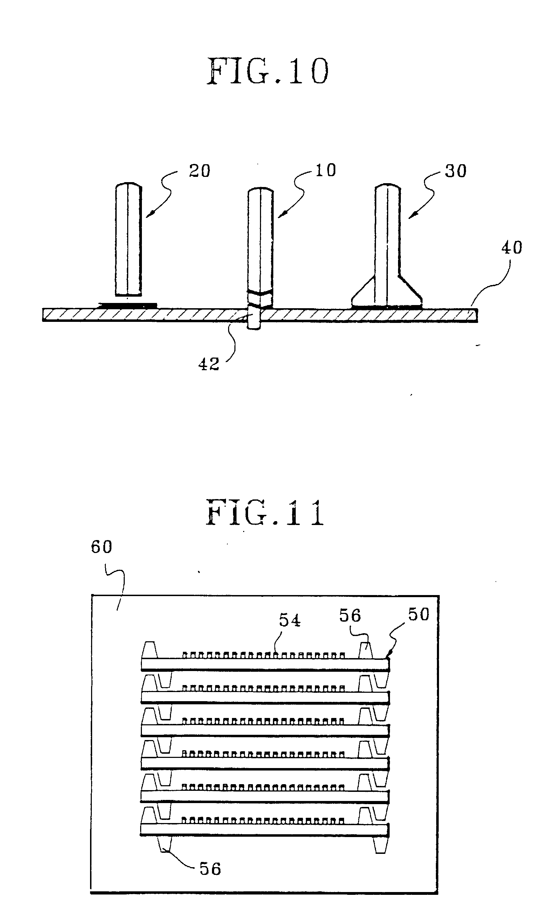

As shown in Figure 10, the end of the support parts 16 are inserted into pierced holes 42 formed on the PCB so that the VPAK 10 is firmly supported. The shoulders 18 abut the upper part of the hole 42, thereby preventing the leads 14 from being deformed.

Figures 3 to 5 of the accompanying drawings show a conventional VSMP 20.

A plurality of leads 24, which are connected to the PCB (not shown), protrude from one side of a rectangular package body 22 on which the semiconductor chip (not shown) is mounted. The leads 24 are all bent in the same direction. A pair of supporting parts 26 are formed at both ends of one side of the package body 22 and are each bent in two directions to support the package body 22. The support parts 26 are made of metal, are longer than the leads 24, and are bent with the leads 24. Thus, the VSMP 20 is adhered on the PCB 40 by soldering, together with the leads 24, and is firmly supported, thereby resisting the leads 24 from being deformed due to external forces.

In the conventional VPAK 10, however, the mounting process is complicated since the piecing holes 42 where the supporting parts 16 are inserted have to be formed additionally so as to mount the VPAK 10 on the PCB 40. Also, the VSMP 20 has a disadvantage that the leads 24 are easily deformed when a thin lead frame is used.

One known mounting package is shown in US Patent No. 5032953. This shows a package having a plurality of leads protruding from one edge, having a pair of supports formed from the same material as the package body and mounted on a PCB. The package is secured to the PCB by soldering the leads. The supports are not attached to the PCB and act to stabilise the package before the leads are soldered.

A known VSMP mounting package is shown in European Patent Publication No. 0427151 which describes a package having a plurality of bent leads protruding from one edge thereof. Support parts are formed at each end of the package formed of the same material as the package body and these supports parts are adhered to the PCB by adhesive to protect the leads from being deformed due to external forces.

An object of the present invention is to provide a semiconductor package which is simple to mount on a PCB.

Another object of the invention is to provide a semiconductor package which prevents the leads from being deformed even when a thin lead frame is used.

According to the present invention, there is provided a vertical surface mount semiconductor device, package including a package body comprising first and second major surfaces joined by a plurality of edge surfaces; a semiconductor chip mounted therein; a plurality of bent leads protruding from a first of said edge surfaces;
supports formed of the same material as said package body, and provided at both ends of said first edge surface of said package; and
a slot formed in said first edge surface between the supports and receiving said plurality of leads so that said supports when mounted on the upper side of a PCB prevent said leads being deformed, characterised in that a first pair of said supports are provided on said first major surface at each end of said first edge surface and a second pair of supports are provided on said second major surface at each end of said first edge surface, each support of the first pair being staggered from the corresponding support of the second pair so that the packages may be mounted close to each other on a PCB.

In a preferred embodiment of the present invention, there is provided an electronic assembly comprising:

a vertical surface mounted semiconductor device package according to claim 1, mechanically mounted to a printed circuit board and electrically connected to electrical connection lines on the printed circuit board.

Embodiments of the present invention will now be described, by way of example and with reference to the accompanying drawings, in which:-
Figure 1 is a front view of a conventional vertical package;
Figure 2 is a side view of a conventional vertical package;
Figure 3 is a front view of a conventional vertical surface mounted package;
Figure 4 is a side view of a conventional vertical surface mounted package;
Figure 5 is a plan view of a conventional vertical surface mounted package;
Figure 6 is a perspective view of a package according to the present invention;
Figure 7 is a front view of a package according to the present invention;
Figure 8 is a side view of a package according to the present invention;
Figure 9 is a plan view of a package according to the present invention;
Figure 10 is a side view of a printed circuit board on which the packages of Figure 1, Figure 3 or Figure 6 are mounted; and
Figure 11 is a plan view of a module in which the packages of Figure 7 are mounted.

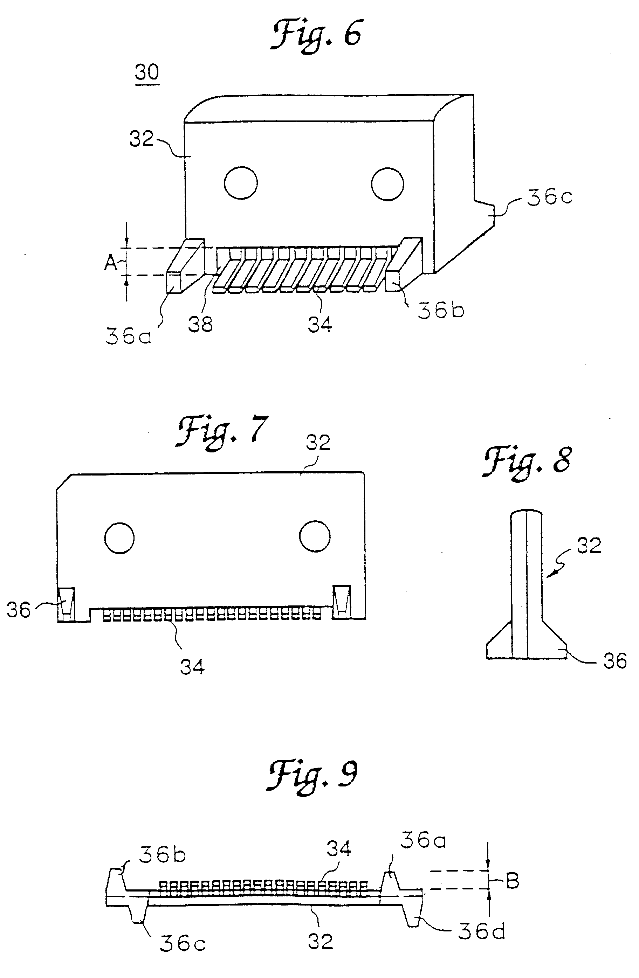

Referring now to the Figures 6 to 9, a VSMP has a package body 32 for protecting a semiconductor chip mounted inside the package 30, the body 32 being formed of EMC by a conventional heating method. At the bottom of the package body 32, metal leads 34 protrude and are bent in the horizontal direction. A pair of supports 36 protrude at both ends of the bottom of the package body 32. The supports 36 are made of the same material as the package body 32, i.e. EMC, and are formed together with the package body 32 during the press-moulding process. Two further supports are formed at the ends of the package body 32, on the opposite side thereof to the first mentioned supports. The further supports are spaced from the end of the package body 32 by a predetermined distance. As shown in Figure 11, this is to improve the packing density by reducing the distance between the packages 30 when they are mounted on the PCB 40.

In addition, a slot 38 is formed between the supports 36, in body 32, to receive the leads 34. The depth A of the slot 38 is equal to or greater than the vertical length of the bent leads 34. The supports 36 may be formed of any desired shape but the bottom of them is made flat so as to be adhered to the PCB by solder or a bonding agent, together with the leads 34. Also, a gap occurs between the bottom of the supports 36 and the package body 32 due to a slow slope, caused by removing the frame after moulding. In order to prevent the gap from occurring, it is conventional to use a moulding method for taking a frame out in vertical direction with the bottom of the supports 36. However, it is preferable to use a moulding method for directly taking a frame out at the bottom of the supports 36, so as to make the lower part of the supports 36 more flat. Also, the horizontal length B of the supports 36 is greater than that of the bent leads 34. Thus, the leads 34 are protected by the slot 38 and the supports 36, and are prevented from being deformed by external forces. Moreover, the supports 36 mount the packages 30 firmly on the PCB 40 as shown in Figure 10.

Figure 11 is a plan view of a module mounted with many semiconductor packages 50 of the type shown in Figure 7.

A plurality of VSMP's 50 are vertically mounted on the PCB 60. Leads 54 and supports 56 are secured to the PCB 60. The supports 56 are, in turn, staggered so as to be interleaved with each other. Thus, the semiconductor packages 50 are mounted close each other, thereby using only a small areas on the PCB 60 and improving the packing density.

As described hereinabove, according to the present invention, the leads protrude from one side of the package body, and the supports are formed at both ends of the package body to mount the package firmly on the PCB, the supports being made of the same material as the package body. Also, in the package body, a slot is formed to receive the leads and the packages can be mounted close to each other.

Thus, there is no additional process step such as forming holes in the PCB to mount the supports of the semiconductor package, and the process of mounting the package becomes simpler. The supports protrude from the package body and mount the package on the PCB firmly. The slot and supports receive the leads to prevent the leads from being deformed by external forces, thereby improving the reliability of the semiconductor package. Also, since the leads are staggered and the packages can be mounted close to each other, the package uses only a small area of the PCB, thereby improving the packing density.

## Claims

1. A vertical surface mount semiconductor device package (30) including a package body (32) comprising first and second major surfaces joined by a plurality of edge surfaces; a semiconductor chip mounted therein; a plurality of bent leads (34) protruding from a first of said edge surfaces;
supports (36) formed of the same material as said package body (32), and provided at both ends of said first edge surface of said package; and
a slot (38) formed in said first edge surface between the supports (36) and receiving said plurality of leads (34) so that said supports when mounted on the upper side of a PCB prevent said leads being deformed, characterised in that a first pair of said supports (36a, 36b) are provided on said first major surface at each end of said first edge surface and a second pair of supports (36c, 36d) are provided on said second major surface at each end of said first edge surface, each support of the first pair being staggered from the corresponding support of the second pair so that the packages may be mounted close to each other on a PCB.

2. A semiconductor device package as claimed in claim 1, wherein the protruding length (B) of said supports (36) from said first and second major surfaces is greater than that of said plurality of bent leads (34) so that said leads (34) are protected from external forces.

3. A semiconductor device package as claimed in claim 1, wherein each of said leads (34) is bent and comprises a first segment perpendicular to said first edge surface and a second segment at an angle to the first segment and the depth (A) of said slot (38) is equal to or greater than the length of the first segment of said bent leads (34).

4. An electronic assembly comprising:
a vertical mounted semiconductor device package according to claim 1, mechanically mounted to a printed circuit board and electrically connected to electrical connection lines on the printed circuit board.

## Patentansprüche

1. Vertikaloberflächenmontierbares Halbleiterbauelementgehäuse (30), umfassend: einen Gehäusekörper (32), der erste und zweite Hauptflächen umfaßt, die durch eine Mehrzahl von Randflächen verbunden sind; einen Halbleiterchip, der darin montiert ist; eine Mehrzahl von gebogenen Anschlüssen (34), die von einer ersten der Randflächen vorstehen;
Abstützungen (36), die aus dem gleichen Material wie der Gehäusekörper (32) gebildet sind und an beiden Enden der ersten Randfläche des Gehäuses vorgesehen sind; und
eine Vertiefung (38), die in der ersten Randfläche zwischen den Abstützungen (36) ausgebildet ist und die Mehrzahl von Anschlüssen (34) aufnimmt, so daß die Abstützungen, wenn sie auf der oberen Seite einer gedruckten Schaltung montiert sind, die Anschlüsse an einer Verformung hindern, **dadurch gekennzeichnet**, daß ein erstes Paar der Abstützungen (36a, 36b) an der ersten Hauptfläche an jedem Ende der ersten Randfläche vorgesehen ist und ein zweites Paar Abstützungen (36c, 36d) an der zweiten Hauptfläche an jedem Ende der ersten Randfläche vorgesehen ist, wobei jede Abstützung des ersten Paares zu der entsprechenden Abstützung des zweiten Paares versetzt angeordnet ist, so daß die Gehäuse eng beieinander auf einer gedruckte Schaltung montiert werden können.

2. Halbleiterbauelementgehäuse nach Anspruch 1, bei welcher die von den ersten und zweiten Hauptflächen vorstehende Länge B der Abstützungen (36) größer ist als diejenige der Mehrzahl von gebogenen Anschlüssen (34), so daß die Anschlüsse (34) vor externen Kräften geschützt sind.

3. Halbleiterbauelementgehäuse nach Anspruch 1, bei welcher jeder der Anschlüsse (34) gebogen ist und ein erstes Segment senkrecht zu der ersten Randfläche und ein zweites Segment in einem Winkel zu dem ersten Segment umfaßt, und die Tiefe A der Vertiefung (38) gleich oder größer als die Länge des ersten Segments der gebogenen Anschlüsse (34) ist.

4. Elektronische Baugruppe, umfassend: ein vertikaloberflächenmontierbares Halbleiterbauelementgehäuse nach Anspruch 1, das auf einer gedruckten Schaltung mechanisch montiert ist und mit elektrischen Verbindungsleitungen auf der gedruckten Schaltung elektrisch verbunden ist, so daß Gehäuse nahe beieinander auf einer gedruckte Schaltung angebracht werden können.

## Revendications

1. Boîtier (30) de dispositif à semi-conducteur pour montage vertical en surface comprenant un corps de boîtier (32) comportant une première et une seconde surfaces principales assemblées par une pluralité de surfaces de bord ; un pastille de semi-conducteur montée à l'intérieur ; une pluralité de connexions coudées (34) dépassant d'une première desdites surfaces de bord ;
des supports (36) formés dans la même matière que le corps de boîtier (32), et prévus aux deux extrémités de ladite première surface de bord dudit boîtier ; et
une fente (38) formée dans ladite première surface de bord entre les supports (36) et recevant ladite pluralité de connexions (34) de façon que lesdits supports une fois montés sur la face supérieure d'une carte PCB empêchent les connexions d'être déformées, caractérisé en ce qu'une première paire desdits supports (36a, 36b) est montée sur ladite première surface principale à chaque extrémité de ladite première surface de bord et une seconde paire de supports (36c, 36d) est prévue sur ladite seconde surface principale à chaque extrémité de ladite première surface de bord, chaque support de la première paire étant décalé par rapport au support correspondant de la seconde paire de manière que les boîtiers puissent être montés rapprochés les uns des autres sur une carte PCB.

2. Boîtier de dispositif à semi-conducteur selon la revendication 1, dans lequel la longueur (B) desdits supports (36) qui dépassent desdites première et seconde surface principales est supérieure à la longueur de ladite pluralité de connexions coudées (34) de façon que lesdites connexions (34) soient protégées des forces externes.

3. Boîtier de dispositif à semi-conducteur selon la revendication 1, dans lequel chacune desdites connexions (34) est coudée et comprend un premier segment perpendiculaire à ladite première surface de bord et un second segment faisant un certain angle par rapport au premier segment et dans lequel la profondeur (A) de ladite fente (38) est égale ou supérieure à la longueur du premier segment desdites connexions coudées (34).

4. Ensemble électronique comprenant :
un boîtier de dispositif à semi-conducteur monté verticalement en surface selon la revendication 1, mécaniquement monté sur une carte de circuit imprimé et électriquement connecté à des lignes électriques de connexion prévues sur la carte de circuit imprimé, de façon que les boîtiers puissent être montés rapprochés les uns des autres sur une carte PCB.
